# EUROPEAN PATENT APPLICATION

(11) **EP 2 432 123 A1**
(43) Date of publication of application: **21.03.2012**
(21) Application number: 11181223.6
(22) Date of filing: 14.09.2011
(51) Int. Cl.: H03H 9/72, H03H 9/00, H03H 9/70

(54) **Duplexer**

(30) Priority: 15.09.2010 JP 2010206780
(71) Applicant: Nihon Dempa Kogyo Co., Ltd., Shibuya-ku Tokyo 151-8569 (JP)
(72) Inventor: Yoshimoto, Susumu, Saitama, 350-1321 (JP)
(74) Representative: TBK

(57) **Abstract**

There is provided a receiving side filter having a good attenuation characteristic in a pass band of a transmitting side filter in a duplexer in which balanced output is performed by the receiving side filter including a longitudinal mode resonator type filter and a pass band of the receiving side filter is set on a lower band side than the pass band of the transmitting side filter. There are provided, between an antenna port 1 and a pair of balanced reception ports 3, 3, a first ladder-type filter 24 including a series arm 22 and a parallel arm 23 each formed of a SAW resonator and a longitudinal mode resonator type filter 25, in this order from the antenna port 1 side, and a second ladder-type filter 26 having series arms 27, 27 formed of SAW resonators and respectively provided in signal paths 36, 36 that connect the respective balanced reception ports 3, 3 and the longitudinal mode resonator type filter 25 and a parallel arm 28 formed of a SAW resonator and connecting between these signal paths 36, 36.

## Description

### BACKGROUND OF THE INVENTION

### 1. FIELD OF THE INVENTION

The present invention relates to a duplexer in which balanced output is performed by a receiving side filter including a longitudinal mode resonator type filter.

### 2. DESCRIPTION OF THE RELATED ART

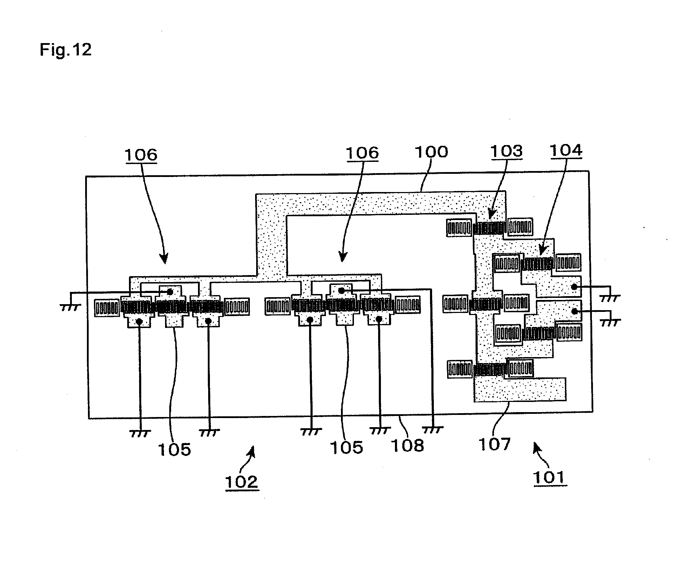

A duplexer used in a portable telephone terminal or a base station for portable telephones includes a transmitting (Tx) side filter 101 and a receiving (Rx) side filter 102 which are connected to a common antenna port 100 as shown in Fig. 12, for example, and in recent years, a duplexer of a type in which differential (balanced) output is performed from the receiving side filter 102 with respect to a pair of reception ports (output ports) 105, 105, has been mainly used. As the transmitting side filter 101, for example, there is used a ladder-type filter in which series arms 103 and parallel arms 104 which are respectively formed of SAW (Surface Acoustic Wave) resonators are connected in a ladder form, and as the receiving side filter 102, longitudinal mode resonator type filters 106 which can easily perform balanced output are used. Further, pass bands of these transmitting side filter 101 and receiving side filter 102 are set to mutually different bands to suppress interference of a transmission signal and a reception signal and set to be approximated to each other as much as possible to prevent an unnecessary (unused) frequency band from being formed. In Fig. 12, 107 denotes a transmission port, and 108 denotes a piezoelectric substrate on which the duplexer is formed. Note that in the duplexer, a not-shown phase shifter is provided to suppress the reception signal from entering the transmitting side filter 101. Further, the transmitting side filter 101 and the receiving side filter 102 are illustrated in a simplified manner in Fig. 12.

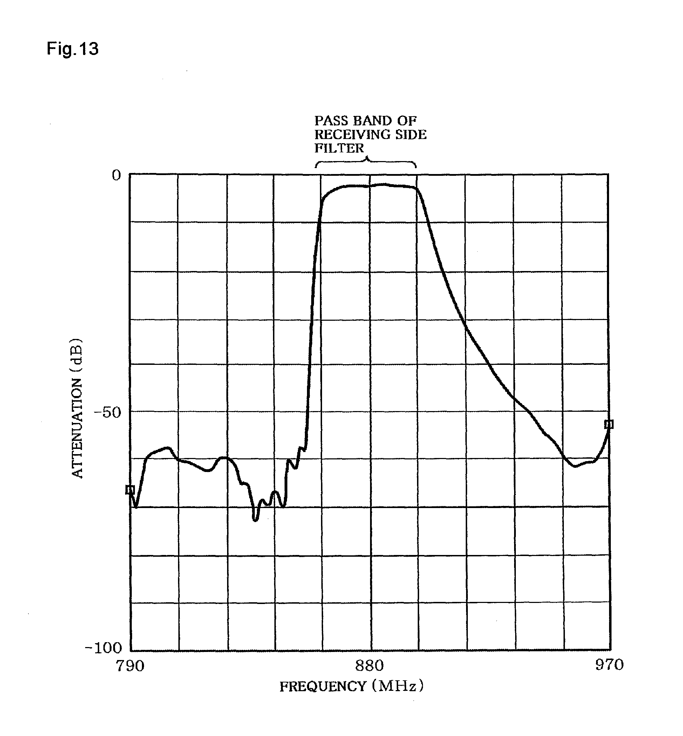

As shown in Fig. 13, for example, the longitudinal mode resonator type filters 106 forming the receiving side filter 102 have a good attenuation characteristic (large attenuation) on a lower band side than the pass band, but, since a gentle slope-shaped curve is formed on a higher band side than the pass band, the attenuation characteristic is deteriorated (the attenuation becomes small) on the high band side, compared with the low band side. Accordingly, in such a duplexer, the pass band of the transmitting side filter 101 is set on the lower band side than the pass band of the receiving side filter 102, in order to increase the attenuation of the receiving side filter 102 in a band corresponding to the pass band of the transmitting side filter 101.

Meanwhile, in recent years, in a process where a frequency band used in a portable terminal has been allocated, there is a case where the pass band of the transmitting side filter 101 is set on the higher band side than the pass band of the receiving side filter 102, as in UMTS FDD Band 13, Band 20 (Band 14) and the like, for example. In this case, if the longitudinal mode resonator type filters 106 are used as the receiving side filter 102, it is difficult to secure, in the receiving side filter 102, the attenuation of about 50 dB, for example, in the pass band of the transmitting side filter 101, as shown in the aforementioned Fig. 13. For this reason, when the pass band of the transmitting side filter 101 is set on the higher band side than the pass band of the receiving side filter 102, in order to increase the attenuation on the higher band side than the pass band of the receiving side filter 102, an unbalanced output ladder-type filter is used as the receiving side filter 102, similar to the transmitting side filter 101, for example. Therefore, in order to realize balanced output from the receiving side filter 102, there is a need to provide an external component called balun or the like, for example, to the outside of the duplexer, and to perform unbalanced-balanced conversion on a signal taken out from one reception port 105 using the external component, resulting in that the duplexer (specifically, an electronic component on which the duplexer is mounted) becomes large in size.

Patent Document 1 describes a filter in which a 1-port type SAW resonator is connected in parallel between each of signal lines connecting two balanced signal terminals 6, 7 and IDTs 81, 85, respectively, and further, Patent Documents 2, 3 describe duplexers. However, these Documents do not describe the aforementioned problems.

[Patent Document 1] Japanese Patent Application Laid-open No. 2006-254410 (Paragraphs 0048 to 0052, Fig. 12)
[Patent Document 2] Japanese Patent Application Laid-open No. 2006-157174
[Patent Document 3] International Publication WO 2007/040052

### SUMMARY OF THE INVENTION

An object of the present invention is to provide a duplexer including a receiving side filter capable of obtaining a good attenuation characteristic in a pass band of a transmitting side filter, the duplexer performing balanced output using the receiving side filter including a longitudinal mode resonator type filter and setting a pass band of the receiving side filter on a lower band side than the pass band of the transmitting side filter.

A duplexer of the present invention having an antenna port, a transmission port, and reception ports formed of balanced signal terminals that receive balanced signals, the duplexer being characterized in that it includes: a transmitting side filter provided between the antenna port and the transmission port and having at least either of elastic wave resonators and an elastic wave filter; and a receiving side filter provided between the antenna port and the reception ports and whose pass band is set on a lower band side than a pass band of the transmitting side filter, in which the receiving side filter includes: a longitudinal mode resonator type filter having an unbalanced-balanced conversion function; a first ladder-type filter provided between the antenna port and the longitudinal mode resonator type filter and in which a series arm and a parallel arm each formed of an elastic wave resonator are connected in a ladder form; and a second ladder-type filter having series arms formed of elastic wave resonators and respectively interposed in a pair of signal paths that connect balanced signal terminals of the longitudinal mode resonator type filter and the balanced signal terminals of the reception ports and a parallel arm formed of an elastic wave resonator and provided between the pair of signal paths.

The present invention provides, in the receiving side filter, the first ladder-type filter in which the series arm and the parallel arm each formed of the elastic wave resonator are connected in a ladder form and the longitudinal mode resonator type filter, in this order from the antenna port side, and the second ladder-type filter having the series arms formed of the elastic wave resonators and respectively interposed in the pair of signal paths that connect the balanced signal terminals of the longitudinal mode resonator type filter and the balanced signal terminals of the reception ports and the parallel arm formed of the elastic wave resonator and provided between the pair of signal paths, between the antenna port and the reception ports formed of the balanced signal terminals. For this reason, a good attenuation characteristic can be obtained on the higher band side than the pass band of the receiving side filter, so that even in a case where the pass band of the transmitting side filter is set on the high band side, it is possible to achieve a duplexer with an excellent attenuation characteristic.

### BRIEF DESCRIPTION OF THE DRAWINGS

Fig. 1 is a plan view showing an example of a duplexer of the present invention;
Fig. 2 is a plan view schematically showing a part of the duplexer in an enlarged manner;
Fig. 3 is a characteristic diagram showing a frequency characteristic obtained in the duplexer;
Fig. 4 is a plan view showing an another example of the duplexer;
Fig. 5 is a plan view showing an another example of the duplexer;
Fig. 6 is a plan view showing an another example of the duplexer;
Fig. 7 is a plan view showing an another example of the duplexer;
Fig. 8 is a schematic view showing an another example of the duplexer;
Fig. 9 is a longitudinal sectional view showing a concrete example of the another example in Fig. 8;
Fig. 10 is a plan view showing an another example of the duplexer;
Fig. 11 is a plan view showing an another example of the duplexer;
Fig. 12 is a plan view showing a conventional duplexer; and
Fig. 13 is a characteristic diagram showing a frequency characteristic obtained in the conventional duplexer.

### DETAILED DESCRIPTION OF THE PREFERRED

### EMBODIMENT(S)

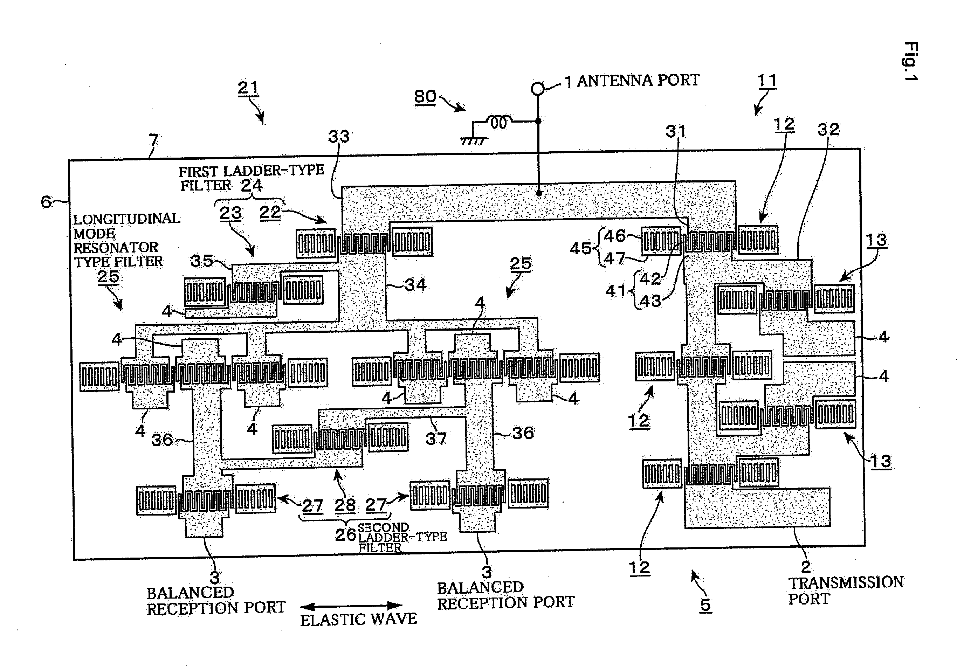

An example of a duplexer of an embodiment of the present invention will be explained with reference to Fig. 1. The duplexer includes: an antenna port 1 which is connected to a not-shown antenna; a transmission port 2 that outputs signals to the outside from a portable telephone terminal or a base station for portable telephones (referred to as "portable terminal or the like", hereinafter) via the antenna port 1; and a pair of balanced (differential) reception ports (output ports) 3, 3 that receive external signals received by the antenna port 1 to transmit them to the portable terminal or the like, and is disposed on a piezoelectric substrate 5 which is formed in a roughly rectangular shape and made of lithium tantalate (LiTaO3), for example. A transmitting (Tx) side filter 11 is provided between the antenna port 1 and the transmission port 2, and a receiving (Rx) side filter 21 is provided between the antenna port 1 and the reception ports 3, 3. There is provided an element 80 for conducting phase adjustment and matching between the antenna port 1 and these transmitting side filter 11 and receiving side filter 21. Note that in a case where the antenna port 1 is provided on the piezoelectric substrate 5, a connection portion connecting the external not-shown antenna, the transmitting side filter 11 and the receiving side filter 21 (connection portion between later-described serial signal path 31 and serial signal path 33) becomes the antenna port 1.

The piezoelectric substrate 5 is structured so that an elastic wave propagates in a direction parallel to long edges 7 out of short edges 6 and the long edges 7 that form an outer edge of the piezoelectric substrate 5. Further, the aforementioned antenna port 1 is disposed in proximity to the long edge 7 being one side of the two long edges 7, 7 of the piezoelectric substrate 5, and the transmission port 2 and the reception ports 3, 3 are respectively disposed in proximity to the long edge 7 being the other side. An impedance with respect to the portable terminal or the like in the transmission port 2 is set to, for example, 50 Ω, and an impedance with respect to the portable terminal or the like in each of the reception ports 3, 3 is set to, for example, 100 Ω to 300 Ω, and is set to 200 Ω in this example.

In the transmitting side filter 11, series arms 12 and parallel arms 13 each formed of a SAW resonator are combined in a ladder form to structure a ladder-type filter. If, on the piezoelectric substrate 5, an area on which the antenna port 1 is formed is referred to as a far side and an area on which the transmission port 2 and the reception ports 3, 3 are disposed is referred to as a near side, in the transmitting side filter 11, three series arms 12 are disposed in one line from the far side toward the near side in this example, and the serial signal path 31 formed of a metal film or the like extending from the antenna port 1 connects each of the series arms 12, 12 adjacent to each other.

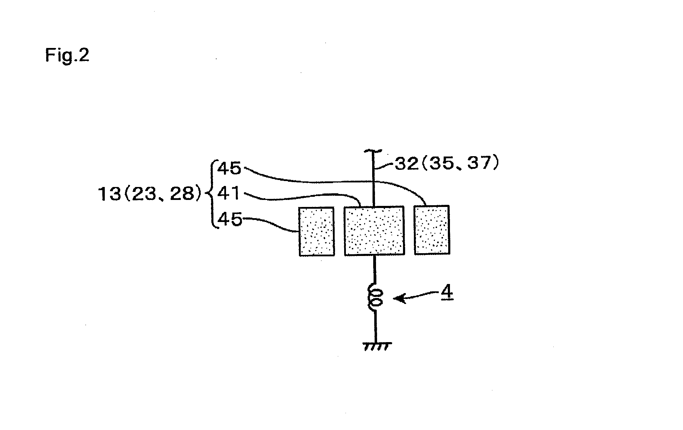

This serial signal path 31 extends to an area which is further on the near side relative to these three series arms 12, and the area forms the aforementioned transmission port 2. Further, one end side of a parallel signal path 32 formed of a metal film or the like is connected between each of the series arms 12, 12 adjacent to each other, and the other end side of each of the parallel signal paths 32 is connected to a ground port 4 via the parallel arm 13. Each of these series arms 12 and parallel arms 13 includes an IDT (interdigital transducer) electrode 41 in which electrode fingers 42 are formed to cross in a comb-teeth shape, and reflectors 45, 45 disposed to sandwich this IDT electrode 41 from both sides in the propagation direction of the elastic wave. Note that, although the conductive path grounded via the ground port 4 from each of the parallel arms 13 includes an inductor component, as in Fig. 2 in which the parallel arm 13 is illustrated in a simplified manner, this is omitted in Fig. 1. The same applies to later-described parallel arms 23, 28.

These series arms 12 and parallel arms 13 are structured so that a pass band formed in the transmitting side filter 11 becomes about 832 MHz to 862 MHz. Concretely, each of arrangement patterns of the electrode fingers 42 of the IDT electrodes 41 and grating electrode fingers 46 of the reflectors 45 in these series arms 12 and parallel arms 13 (length of wavelength of excited elastic wave) is set so that a series resonance frequency (resonance point) in the series arm 12 and a parallel resonance frequency (antiresonance point) in the parallel arm 13 become the same at a frequency within the aforementioned pass band, which is, for example, 847 MHz. In Fig. 1, 43 denotes a bus bar of the IDT electrode 41, and 47 denotes a grating bus bar of the reflector 45. Note that in Fig. 1, the IDT electrodes 41 and the reflectors 45 are schematically illustrated in a simplified manner.

Next, the receiving side filter 21 will be described in detail. When the piezoelectric substrate 5 is seen from the near side toward the far side, the receiving side filter 21 is disposed on the left side with respect to the aforementioned transmitting side filter 11. Further, in the receiving side filter 21, a first ladder-type filter 24 in which a series arm 22 and a parallel arm 23 each formed of a SAW resonator are combined in a ladder form, longitudinal mode resonator type filters 25 having an unbalanced-balanced conversion function, and a second ladder-type filter 26 in which series arms 27 and a parallel arm 28 each formed of a SAW resonator are combined in a ladder form, are connected in this order from the antenna port 1 side toward the side of the reception ports 3, 3. In this example, there are provided two longitudinal mode resonator type filters 25.

Each of the series arm 22 and the parallel arm 23 in the first ladder-type filter 24 is formed of the aforementioned IDT electrode 41 and the reflectors 45, 45 disposed on both sides of the IDT electrode 41 in the propagation direction of the elastic wave. The bus bar 43 on the far side of the series arm 22 is connected to the antenna port 1 via the serial signal path 33. One end side of a serial signal path 34 is connected to the bus bar 43 on the near side of the series arm 22, and the other end side of the serial signal path 34 is branched into two paths, which respectively extend toward the longitudinal mode resonator type filters 25, 25. To the serial signal path 34 between the series arm 22 and these longitudinal mode resonator type filters 25, 25, a parallel signal path 35 extending from the bus bar 43 on the far side of the parallel arm 23 is connected. The bus bar 43 on the near side of the parallel arm 23 extends to the side of the short edge 6 of the piezoelectric substrate 5 to form the ground port 4.

Each of the longitudinal mode resonator type filters 25, 25 includes three IDT electrodes 41 disposed along the propagation direction of the elastic wave, and the reflectors 45, 45 disposed on one end side and the other end side of a row of these IDT electrodes 41. In each of the longitudinal mode resonator type filters 25, the aforementioned serial signal path 34 is connected to each of the bus bars 43 on the far side of the IDT electrodes 41, 41 on both sides among the three IDT electrodes 41, and the bus bars 43 on the near side of these IDT electrodes 41, 41 respectively extend to the near side to form the ground ports 4. Further, regarding each of the center IDT electrodes 41 of the longitudinal mode resonator type filters 25, 25, the bus bar 43 on the far side forms the ground port 4, and to the bus bar 43 on the near side, one end side of a serial signal path 36 extending toward the reception port 3 is connected. In the longitudinal mode resonator type filters 25, 25, the bus bars 43, 43 on the near side in the respective center IDT electrodes 41 form balanced signal terminals, respectively.

The series arms 27 each formed of the SAW resonator are interposed in the serial signal paths 36 between the respective longitudinal mode resonator type filters 25 and the balanced signal terminals of the reception ports 3. Further, there is provided the parallel arm 28 formed of the SAW resonator so as to connect between the serial signal path 36 between one longitudinal mode resonator type filter 25 out of the two longitudinal mode resonator type filters 25, 25 and the series arm 27 and the serial signal path 36 between the other longitudinal mode resonator type filter 25 and the series arm 27. The parallel arm 28 is connected to these serial signal paths 36, 36 via a parallel signal path 37. These two series arms 27, 27 and one parallel arm 28 form the second ladder-type filter 26. Each of the series arms 27 and the parallel arm 28 includes the aforementioned IDT electrode 41 and two reflectors 45, 45.

Regarding the receiving side filter 21, a wavelength of elastic wave that propagates in the receiving side filter 21 is set so that a pass band of the receiving side filter 21 positions at, for example, 791 MHz to 821 MHz, which is on the lower band side than a pass band of the transmitting side filter 11. Specifically, the pass band of the receiving side filter 21 is adjacent to the pass band of the transmitting side filter 11 from the low band side. Concretely, arrangement patterns of the electrode fingers 42 and the grating electrode fingers 46 in these series arms 22, 27 and parallel arms 23, 28 are set so that a resonance point in each of the series arms 22, 27 and an antiresonance point in each of the parallel arms 23, 28 become the same at a frequency within the pass band of the receiving side filter 21, which is, for example, 806 MHz. Further, regarding the longitudinal mode resonator type filters 25, 25, arrangement patterns of the electrode fingers 42 and the grating electrode fingers 46 are set so that an elastic wave with a wavelength corresponding to, for example, 806 MHz, which is a center frequency in the pass band of the receiving side filter 21 propagates, for example. In each of the longitudinal mode resonator type filters 25, 25, the respective electrode fingers 42 are arranged so that a phase of mutual signals received in the pair of reception ports 3, 3 is changed by 180°.

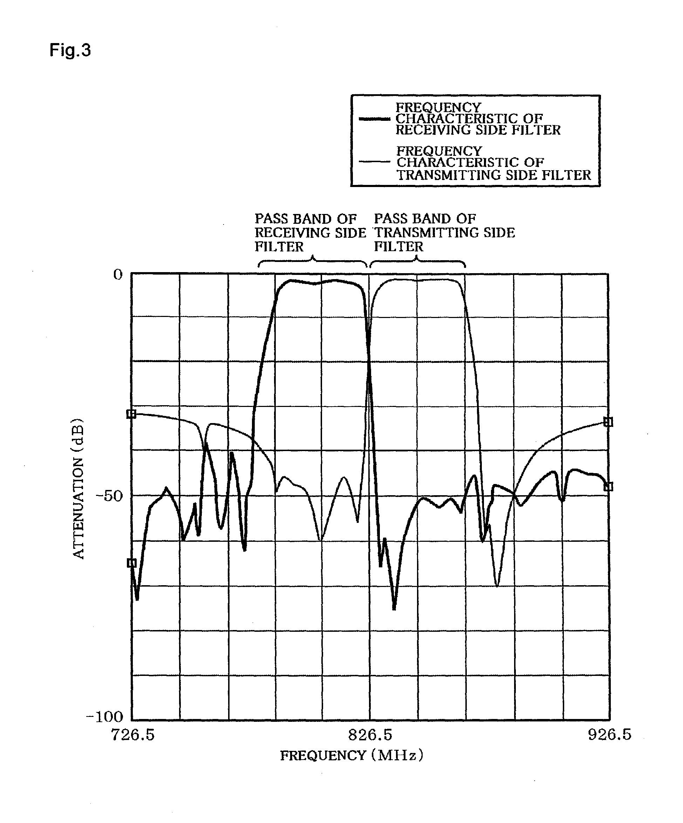

In this duplexer, a signal of, for example, 832 MHz to 862 MHz is transmitted to the outside from the portable terminal or the like via the transmission port 2, the transmitting side filter 11 and the antenna port 1. Further, a signal of, for example, 791 MHz to 821 MHz from the outside is received by the portable terminal or the like via the antenna port 1, the receiving side filter 21 and the pair of reception ports 3, 3. At this time, the first ladder-type filter 24 and the second ladder-type filter 26 in addition to the longitudinal mode resonator type filters 25, 25 are provided as the receiving side filter 21, so that in the receiving side filter 21, an attenuation in a band corresponding to the pass band of the transmitting side filter 11 is extremely large, as shown in Fig. 3. For this reason, even if a signal transmitted toward the antenna port 1 from the transmitting side filter 11 enters the receiving side filter 21, the signal can be attenuated in the receiving side filter 21, resulting in that interference and adverse effect due to this signal become extremely small in the receiving side filter 21.

According to the aforementioned embodiment, since the first ladder-type filter 24, the longitudinal mode resonator type filters 25 and the second ladder-type filter 26 are provided in this order from the antenna port 1 side between the antenna port 1 and the pair of reception ports 3, 3, it is possible to obtain an extremely large attenuation (obtain a good attenuation characteristic) on the higher band side than the pass band of the receiving side filter 21. For this reason, even in a case where the pass bands of the filters are set so that the pass band of the transmitting side filter 11 is adjacent to the pass band of the receiving side filter 21 from the high band side, it is possible to obtain, in the receiving side filter 21, a large attenuation equal to about 50 dB in the band corresponding to the pass band of the transmitting side filter 11. Therefore, by applying the receiving side filter 21 of the present invention to the duplexer of a type in which the balanced output with respect to the pair of reception ports 3, 3 is performed by using the longitudinal mode resonator type filters 25 and the pass band of the transmitting side filter 11 is set on the higher band side than the pass band of the receiving side filter 21, it is possible to obtain a duplexer excellent in the attenuation characteristic.

Further, when the balanced output with respect to the pair of transmission ports 3, 3 is performed, not the ladder-type filter but the longitudinal mode resonator type filters 25 are used as the receiving side filter 21, so that there is no need to provide a component for performing unbalanced-balanced conversion to the outside of the duplexer, for example. Accordingly, it is possible to perform the balanced output while suppressing the increase in size of the duplexer or the electronic component on which the duplexer is mounted.

Further, the output impedance of the reception ports 3, 3 with respect to the portable terminal or the like is set higher than the impedance with respect to the portable terminal or the like in the transmission port 2, as described above. For this reason, by providing the ladder-type filters 24, 26 on the receiving side filter 21 side, not on the transmitting side filter 11 side, the impedance of these ladder-type filters 24, 26 can also match the impedance of the reception ports 3, 3. Accordingly, the sizes of these ladder-type filters 24, 26 can be reduced, resulting in that a duplexer having a small size and excellent attenuation characteristic can be obtained.

Furthermore, since the first ladder-type filter 24 is disposed further on the antenna port 1 side relative to the longitudinal mode resonator type filters 25, 25, the first ladder-type filter 24 also plays a role of a sort of phase shifter, which enables to suppress a signal from entering the receiving side filter 21 side from the transmitting side filter 11 side.
Further, since the ladder-type filters 24 (26) are disposed on both sides of a previous stage (antenna port 1 side) and a subsequent stage (reception ports 3, 3 side) of the longitudinal mode resonator type filters 25, 25, it is possible to easily adjust input/output terminal impedances (impedance of the receiving side filter 21 with respect to the antenna port 1 and impedance of the receiving side filter 21 with respect to the reception ports 3, 3). Further, when the SAW resonators are disposed as the series arms, resistance to ESD (Electric static discharge) becomes high, so that by disposing the series arms 22, 27 on the previous stage side and the subsequent stage side of the longitudinal mode resonator type filters 25, it is possible to obtain a duplexer excellent in ESD resistance.
Furthermore, even if a phase of one signal out of two signals output to the portable terminal or the like from the pair of reception ports 3, 3 attempts to shift, for instance, since the parallel arm 28 is provided in parallel between the two serial signal paths 36, 36, the phase shift in these reception ports 3, 3 is sort of neutralized, resulting in that a phase balance between the pair of reception ports 3, 3 can be adjusted.

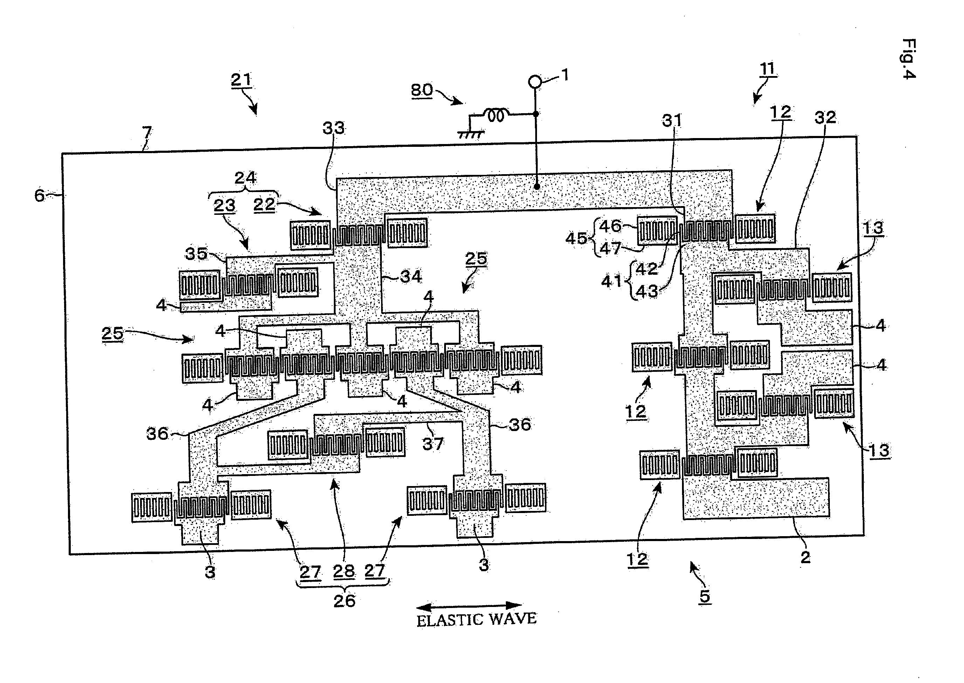

Although, in the aforementioned example, two longitudinal mode resonator type filters 25, 25 are provided in the receiving side filter 21, the longitudinal mode resonator type filter 25 is for converting an unbalanced signal into a balanced signal, and accordingly, it is also possible that only one of the filters is provided. Fig. 4 shows an example where only one longitudinal mode resonator type filter 25 is disposed. The longitudinal mode resonator type filter 25 includes five IDT electrodes 41 disposed along the propagation direction of the elastic wave, and the reflectors 45, 45 provided on one end side and the other end side of a row of these IDT electrodes 41.

The serial signal path 34 is connected to each of the bus bars 43 on the far side of the IDT electrodes 41, 41 on both sides and the center IDT electrode 41 among these five IDT electrodes 41, and the bus bars 43 on the near side of these IDT electrodes 41 form the ground ports 4. Further, regarding the respective IDT electrodes 41 disposed between these IDT electrodes 41, 41 whose bus bars 43 on the far side are connected to the serial signal paths 34, the bus bars 43 on the far side form the ground ports 4, and the serial signal paths 36 connected to the bus bars 43 on the near side respectively extend toward the reception ports 3. Also in this example, it is possible to obtain a large attenuation on the higher band side than the pass band of the receiving side filter 21, as described above. As above, the number of IDT electrodes 41 in the longitudinal mode resonator type filter 25 and the number of longitudinal mode resonator type filters 25 are only required to be set so that the balanced output from the pair of reception ports 3, 3 can be realized.

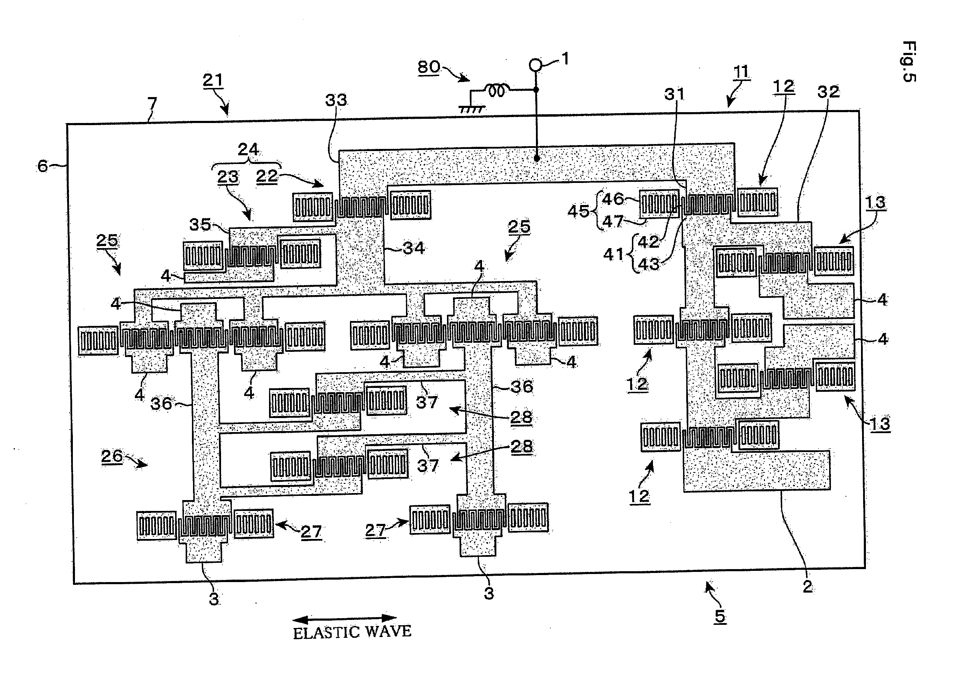

Further, regarding the second ladder-type filter 26, it is also possible to dispose two parallel arms 28 connected in parallel with respect to two serial signal paths 36, 36 between the reception ports 3, 3 and the longitudinal mode resonator type filters 25, as shown in Fig. 5. In this case, it is possible to obtain a larger attenuation on the higher band side than the pass band of the receiving side filter 21.

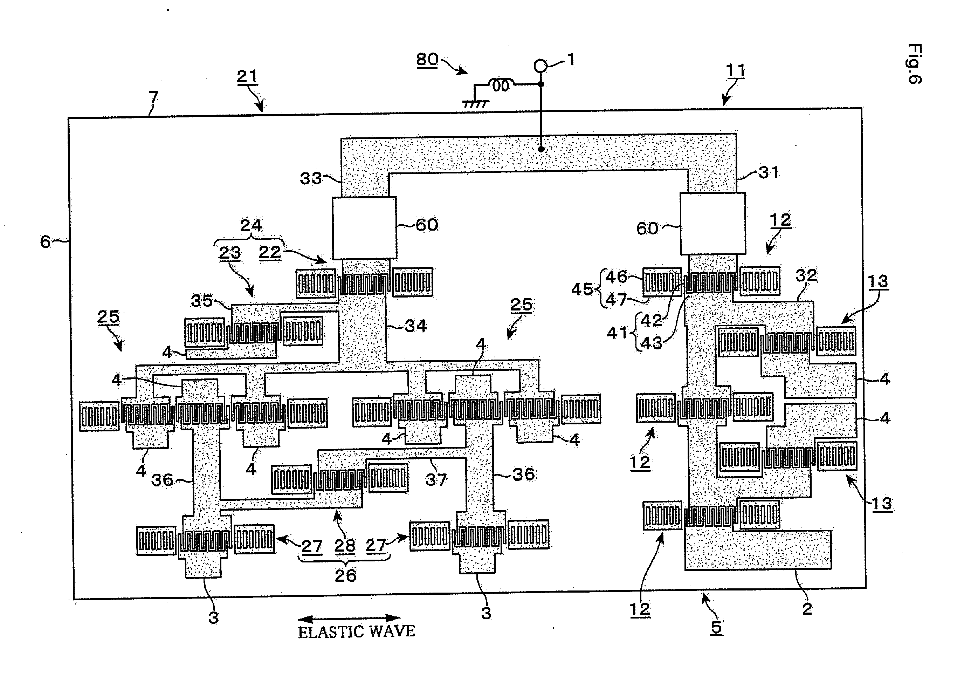

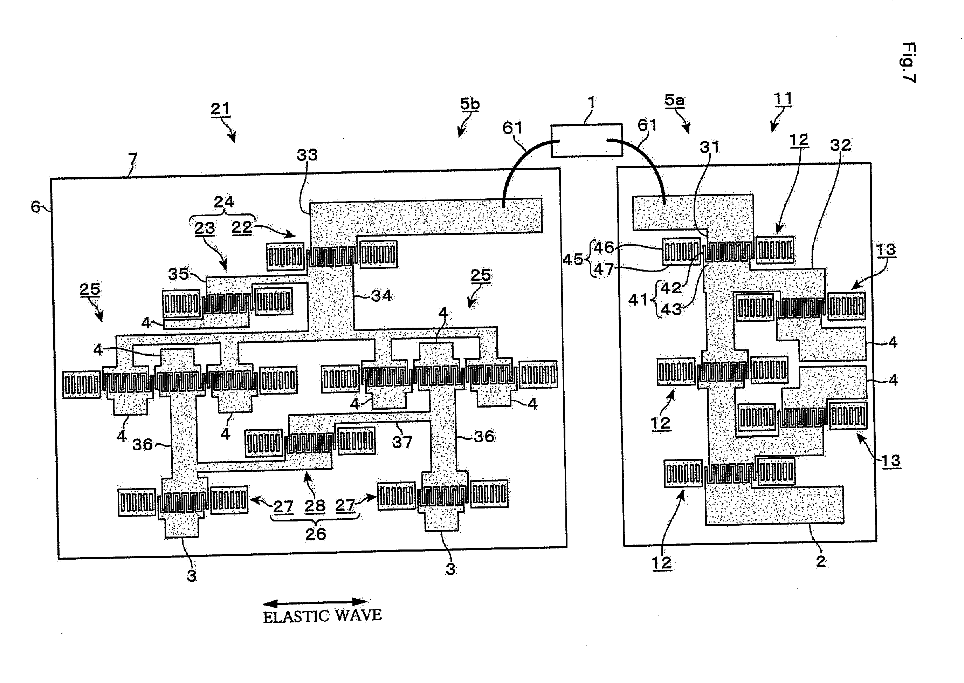

Further, as shown in Fig. 6, it is also possible to provide phase shifters 60, 60 formed of transmission lines, inductors and capacitors for conducting phase adjustment and matching, between the antenna port 1 and the transmitting side filter 11 and between the antenna port 1 and the receiving side filter 21.
Furthermore, it is also possible to dispose the transmitting side filter 11 and the receiving side filter 21 on separate piezoelectric substrates 5a, 5b, respectively, as shown in Fig. 7. In this case, the piezoelectric substrates 5a, 5b are respectively disposed on a not-shown substrate made of alumina or the like, for example, and the serial signal paths 31, 33 respectively extending from these filters 11, 21 are respectively connected to the antenna port 1 provided on the substrate via wires 61 or the like, for example. Further, it is also possible that these transmitting side filter 11 and receiving side filter 21 are housed in separate packages and sealed, and these filters 11, 21 are mounted on one portable terminal or the like and connected to a common antenna.

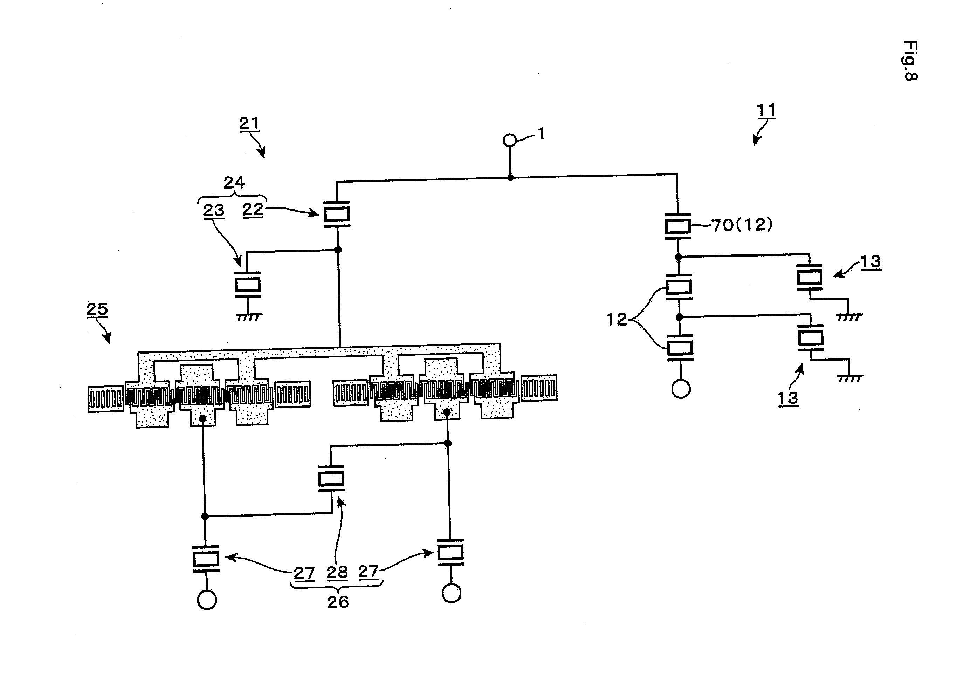

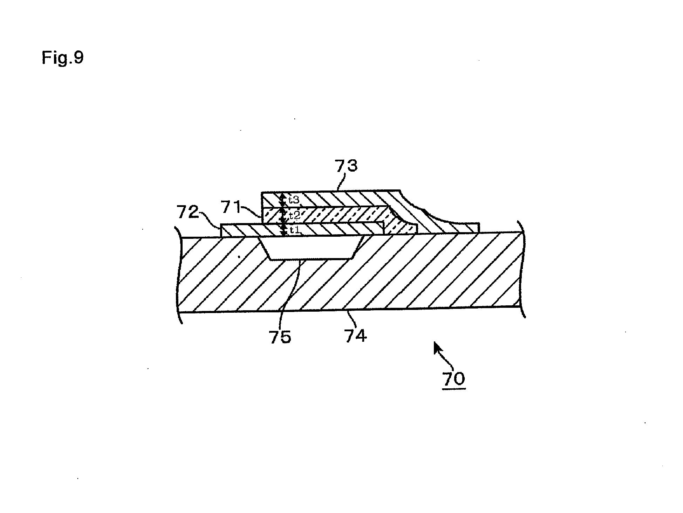

Further, in the aforementioned examples, the SAW resonators utilizing surface acoustic wave are disposed as the series arms 12, 22, 27 and the parallel arms 13, 23, 28 in the respective filters 11, 21, but, it is also possible to use as the SAW resonators ,the one port SAW resonators, or the two ports SAW resonators, or as shown in Fig. 8, an elastic wave resonator 70 utilizing elastic wave that propagates in an internal area of the piezoelectric substrate 5 which is, for example, an FBAR (Film Bulk Acoustic Resonator), an SMR (Solid Mounted Resonator) or a BAWR (Bulk Acoustic Wave Resonator). Specifically, the SAW resonators are included in the elastic wave resonators. It is only required to structure the receiving side filter 21 of the present invention so that the longitudinal mode resonator type filter 25 for performing the balanced output with respect to the pair of reception ports 3, 3 utilizes the surface acoustic wave. In a case where the elastic wave resonator 70 other than the SAW resonator, which is, for example, the FBAR is used, at a time of setting the pass band as described above, it is also possible to adjust a film thickness t2 of a piezoelectric thin film 71 used in the elastic wave resonator 70 or adjust, not the film thickness t2 but, or in addition to the film thickness t2, at least either of respective film thicknesses t1 and t3 of a lower electrode 72 and an upper electrode 73, as shown in Fig. 9. Further, the transmitting side filter 11 may also have an elastic wave filter(a structure in which the longitudinal mode resonator type filter, the SAW filter, the FBAR filter, the dielectric filter )is used instead of the resonators or together with the resonators, other than the aforementioned elastic wave filter in which the resonators are connected in a ladder form. Note that in Fig. 8, the elastic wave resonators 70 and signal paths are illustrated in a simplified manner. Further, in Fig. 9, 74 denotes a substrate made of silicon (Si) or the like, for example, and 75 denotes a recessed portion (gap) formed on the substrate 74.

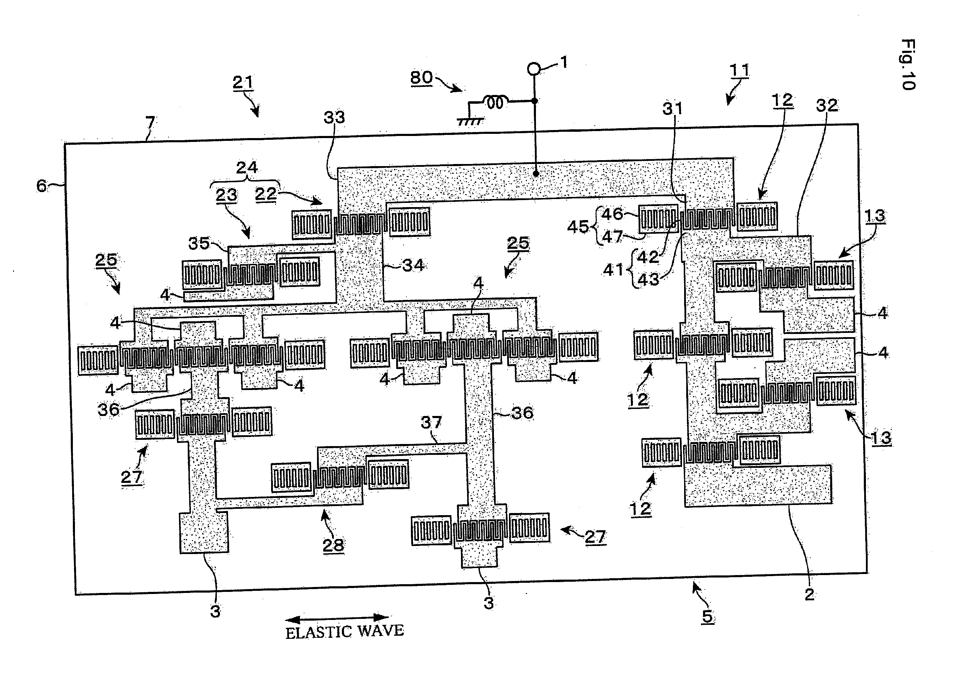

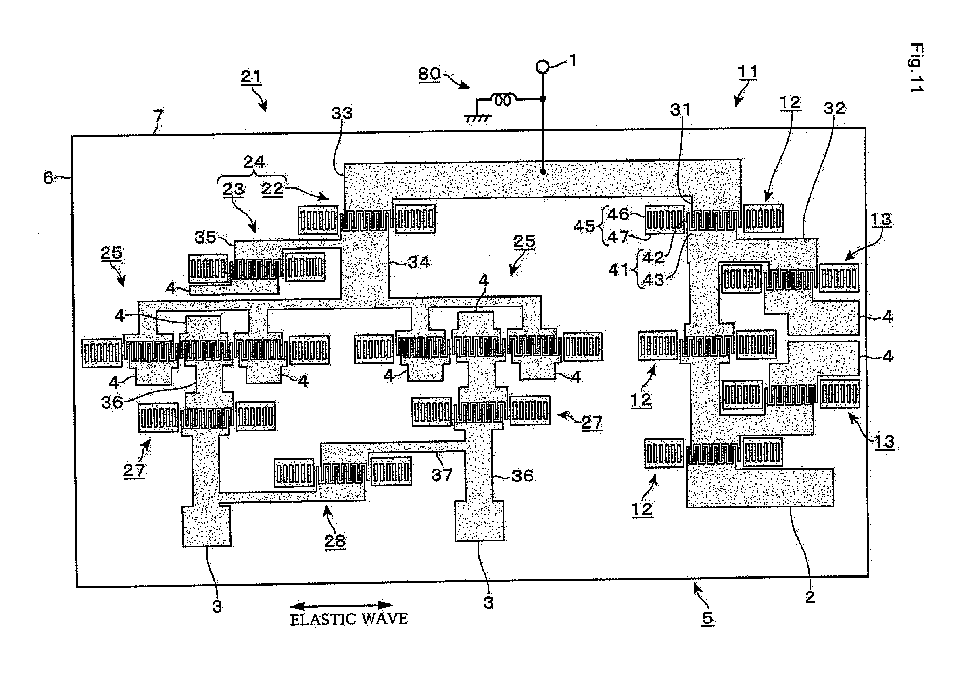

Here, an another structure of the second ladder-type filter 26 will be explained with reference to Fig. 10 and Fig. 11. In the aforementioned examples, the parallel arm (arms) 28 is (are) connected between the series arms 27, 27 and the longitudinal mode resonator type filter (filters) 25, but, as shown in Fig. 10, it is also possible to connect one end side of the parallel signal path 37 in which the parallel arm 28 is interposed, between the series arm 27 and the reception port 3. Further, as shown in Fig. 11, it is also possible to connect one end side and the other end side of the parallel signal path 37, between the series arm 27 being one side out of the two series arms 27 and the reception port 3 and between the other series arm 27 and the reception port 3, respectively.

Further, as the piezoelectric substrate 5, it is also possible to use a substrate having a piezoelectric function made of, not the aforementioned lithium tantalate but quartz crystal, lithium niobate (LiNbO3) or the like, or it is also possible to use a substrate obtained by forming one layer or more of thin film having the piezoelectric function on a substrate having a piezoelectric property or a substrate with no piezoelectric property.
There is provided a receiving side filter having a good attenuation characteristic in a pass band of a transmitting side filter in a duplexer in which balanced output is performed by the receiving side filter including a longitudinal mode resonator type filter and a pass band of the receiving side filter is set on a lower band side than the pass band of the transmitting side filter. There are provided, between an antenna port 1 and a pair of balanced reception ports 3, 3, a first ladder-type filter 24 including a series arm 22 and a parallel arm 23 each formed of a SAW resonator and a longitudinal mode resonator type filter 25, in this order from the antenna port 1 side, and a second ladder-type filter 26 having series arms 27, 27 formed of SAW resonators and respectively provided in signal paths 36, 36 that connect the respective balanced reception ports 3, 3 and the longitudinal mode resonator type filter 25 and a parallel arm 28 formed of a SAW resonator and connecting between these signal paths 36, 36.

## Claims

1. A duplexer having an antenna port, a transmission port, and reception ports formed of balanced signal terminals that receive balanced signals, the duplexer comprising:
a transmitting side filter provided between the antenna port and the transmission port and having at least either of elastic wave resonators and an elastic wave filter; and
a receiving side filter provided between the antenna port and the reception ports and whose pass band is set on a lower band side than a pass band of said transmitting side filter, wherein
said receiving side filter comprises:
a longitudinal mode resonator type filter having an unbalanced-balanced conversion function;
a first ladder-type filter provided between the antenna port and said longitudinal mode resonator type filter and in which a series arm and a parallel arm each formed of an elastic wave resonator are connected in a ladder form; and
a second ladder-type filter having series arms formed of elastic wave resonators and respectively interposed in a pair of signal paths that connect balanced signal terminals of said longitudinal mode resonator type filter and the balanced signal terminals of the reception ports and a parallel arm formed of an elastic wave resonator and provided between the pair of signal paths.
